# EUROPÄISCHE PATENTSCHRIFT

(11) **EP 0 508 003 B1**
(45) Veröffentlichungstag und Bekanntmachung des Hinweises auf die Patenterteilung: **09.02.1994**
(21) Anmeldenummer: 91303068.0
(22) Anmeldetag: 08.04.1991
(51) Int. Cl.: H05K 5/04

(54) **Kassette zum Einbau in einen Baugruppenträger**
Casing to be built into a component rack
Casette à monter dans une boîte pour des cartes électroniques

(43) Veröffentlichungstag der Anmeldung: 14.10.1992
(73) Patentinhaber: Rittal-Werk Rudolf Loh GmbH & Co. KG, 35745 Herborn (DE)
(72) Erfinder: Fursier, Roger, Saltash, Cornwall (GB); Keens, Gary, Roborough, Plymouth (GB)
(74) Vertreter: Jeck, Anton, Dipl.-Ing.

(56) Entgegenhaltungen:
- DE-A- 2 732 139
- DE-A- 3 503 813
- DE-U- 8 711 521
- GB-A- 2 044 545

## Beschreibung

Die Erfindung betrifft eine Kassette zum Einbau in einen Baugruppenträger mit Führungsschienen für einschiebbare Leiterplatten.

Eine derartige Kassette ist aus DE-A1-3503813 bekannt.

Trägt jede Leiterplatte einen Steckverbinder und eine Frontplatte, dann ist sie mittels zweier aufeinander ausgerichteter Führungsschienen ohne Schwierigkeiten in dem Baugruppenträger festlegbar. Nun tritt aber immer häufiger der Fall auf, daß neben einer Leiterplatte auch zusätzliche Baugruppen zu einer Moduleinheit zusammengefaßt werden müssen, die als solche in den Baugruppenträger und aus diesem wieder entnommen werden muß. Dabei tritt häufig noch der Wunsch auf, daß diese Moduleinheit abgeschirmt in den Baugruppenträger eingesetzt werden muß.

Es ist Aufgabe der Erfindung, eine Kassette der eingangs erwähnten Art zu schaffen, die eine Moduleinheit wahlweise offen oder abgeschirmt aufnehmen kann und als komplette Einheit in den Baugruppenträger eingesetzt werden kann.

Diese Aufgabe wird nach der Erfindung dadurch gelöst, daß die Kassette aus zwei identischen Seitenplatten, einer Boden- und einer Deckplatte, einer Frontplatte und einer Rückwand zusammengesetzt ist, daß die Seitenplatten an ihren von der Frontplatte zur Rückwand verlaufenden Längskanten mit nach innen versetzten, horizontalen Befestigungsflanschen zum Anbringen der Boden- und der Deckplatte versehen sind, daß die Seitenplatten in den Eckbereichen, d.h. an den Übergängen zu den Befestigungsflanschen mit zum Einschieben in Führungsschienen auf die Aufnahmenuten der Führungsschienen abgestimmten und ausgerichteten vertikalen Führungsstegen versehen sind, daß aus den Seitenplatten Fenster ausgestanzt sind, daß die ausgestanzten Seitenplattenteile wieder in die Fenster der Seitenplatten einsetzbar und darin festlegbar sind, daß die vertikalen Stirnseiten der Seitenplatten mit Gewindebohrungen versehen sind und daß die Frontplatte und die Rückwand entsprechend verteilte Bohrungen zur Aufnahme von Befestigungsschrauben tragen.

Mit den Seitenplatten, der Frontplatte und der Rückwand kann eine offene Kassette zusammengesetzt werden, die mit der Bodenplatte und der Deckplatte sowie den ausgestanzten Seitenplattenteile zu einer abgeschirmten, vollständig geschlossenen Kassette vervollständigt werden kann. Die Bodenplatte und die Deckplatte sind dabei identisch ausgebildet.

Die Breite der Kassette wird allein durch die Breite der Frontplatte und der Rückwand festgelegt.

Ist nach einer Ausgestaltung vorgesehen, daß die Seitenplatten auf den einander zugekehrten Innenseiten mindestens einen durchgehend angeformten Schraubkanal aufweisen, der zumindest in den an die vertikalen Stirnseiten der Seitenplatten anschließenden Bereichen als Gewindebohrungen ausgebildet ist, dann lassen sich die Frontplatte und die Rückwand leicht mit den Seitenplatten verschrauben.

Der Aufwand an Schraubverbindungen wird dadurch reduziert, daß ein einziger Schraubkanal etwa in der Mitte der Höhe der Seitenplatten angeformt ist und sich über die ausgestanzten Seitenplattenteile erstreckt. Ist dabei vorgesehen, daß die Fenster in den Seitenplatten bis auf einen schmalen Steg an die vertikalen Stirnseiten der Seitenplatten herangeführt sind, und daß die Enden des Schraubkanals in den Seitenplattenteilen als Gewindeaufnahmen ausgebildet sind, dann läßt sich dieser Schraubkanal auch zur Festlegung der ausgestanzten Seitenplattenteilen in den Fenstern der Seitenplatten verwenden, wozu dieselben Befestigungsscheiben ausgenützt werden, die zum Anbringen der Frontplatte und der Rückwand erforderlich sind.

Das Anbringen der Bodenplatte und der Deckplatte an einer offenen Kassette wird dadurch erleichtert, daß die Befestigungsflansche der Seitenplatten vertikal nach außen abstehende Abschlußstege tragen, die die Aufnahmen für die Boden- und Deckplatte begrenzen. Die Abschlußstege bilden eine Aufnahme für die Bodenplatte und die Deckplatte. Zum Anbringen derselben ist vorgesehen, daß die Befestigungsflansche mit Gewindebohrungen und die Boden- und die Deckplatte mit darauf abgestimmten und ausgerichteten Befestigungsbohrungen versehen sind.

In die Kassette können gleich große Leiterplatten wie in den Baugruppenträger eingesetzt werden, wenn vorgesehen ist, daß die Befestigungsflansche auf ein einander zugekehrten Innenseiten als Führungsschiene zur Aufnahme einer Leiterplatte ausgebildet sind, die in gleicher horizontaler Ebene wie die an den zugeordneten Längskanten der Seitenplatten angeformten Führungsstege angeordnet sind.

Der Anschluß der in der Kassette untergebrachten Moduleinheit in dem Baugruppenträger wird dadurch ermöglicht, daß die Rückwand zumindest in dem an eine Seitenplatte anschließenden Bereich mit einer Aussparung zum Durchführen eines Steckverbinders einer in den zugekehrten Führungsschienen der Seitenplatte eingeschobenen Leiterplatte versehen ist. Damit läßt sich die Kassette wie eine Leiterplatte an entsprechenden komplementären, im Baugruppenträger festgelegten Steckverbindern anschließen.

Nach einer weiteren Ausgestaltung ist vorgesehen, daß die Rückwand an ihren horizontalen Kanten abgewinkelte Flansche aufweist, die zwischen die zugekehrten Befestigungsflansche der Seitenplatten einführbar sind.

Die Seitenplatten mit den Fixierstiften lassen sich am einfachsten als Metall-Spritzgußteil herstellen.

Die Frontplatte und die Rückwand läßt sich mit nur zwei Befestigungsschrauben an den Seitenplatten eindeutig unverdrehbar festlegen, wenn vorgesehen ist, daß die Frontplatte und die Rückwand durch zusätzliche Fixierstifte unverdrehbar an den Stirnseiten der Seitenplatten festgelegt sind.

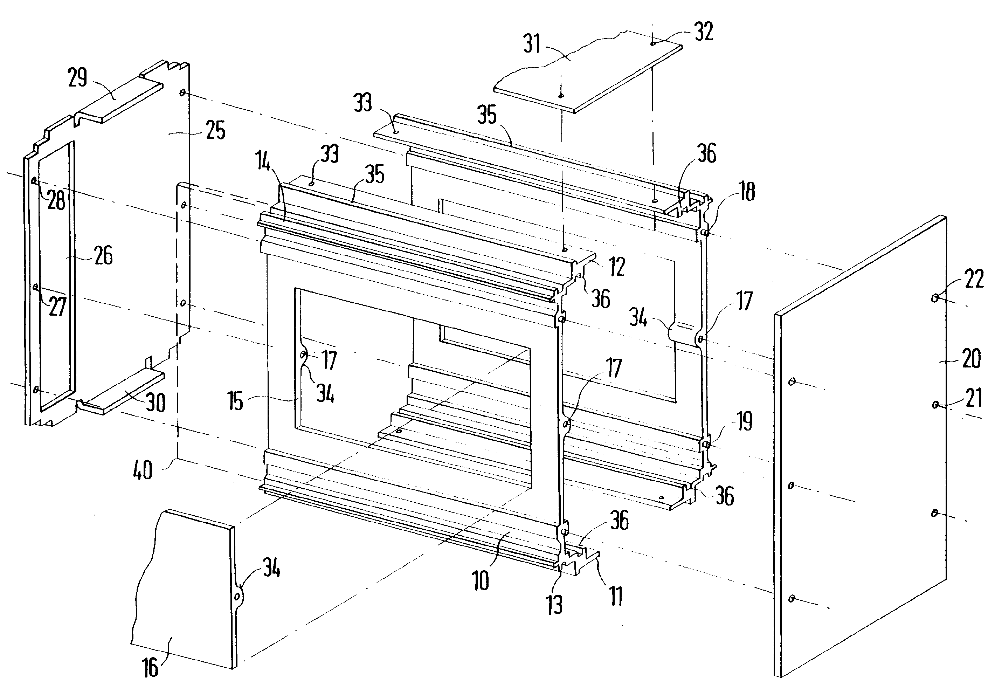

Die Erfindung wird anhand eines in der Zeichnung in Explosionsdarstellung wiedergegebenen Ausführungsbeispiel näher erläutert.

Eine Kassette zum Einbau in einen Baugruppenträger ist nach der Erfindung aus zwei identischen Seitenplatten 10, einer Frontplatte 20 und einer Rückwand 25 zusammengesetzt, wenn sie nicht abgeschirmt sein muß und Öffnungen zur Belüftung aufweisen soll. Dies ist in der Regel dann der Fall, wenn die Kassette eine Moduleinheit aufnimmt, die wärmeabgebende Bauelemente enthält. Die Seitenplatten 10 werden vorzugsweise als Abschnitte eines Metall-Extruderprofils hergestellt und danach mit einem Fenster 15 versehen. Die ausgestanzten Seitenplattenteile 16 sind in die Fenster 15 wieder einsetzbar und darin festlegbar. Auf den einander zugekehrten Innenseiten der Seitenplatten 10 ist jeweils etwa in der Mitte der Höhe der Seitenplatten 10 ein Schraubkanal 34 angeformt, der an den beiden vertikalen Stirnseiten der Seitenplatten 10 als Gewindebohrung 17 ausläuft. Die Enden des Schraubkanals 34 an den ausgestanzten Seitenplattenteile 16 werden ebenfalls an beiden Enden als Gewindeaufnahmen ausgebildet. Die Enden der Schraubkanäle 34 an den Stirnseiten der Seitenplatten 10 fluchten und können gemeinsame Befestigungsschrauben aufnehmen, die gleichzeitig die Frontplatte 20 oder die Rückwand 25 und die ausgestanzten Seitenplattenteile 16 an den Seitenplatten 10 festlegen.

Die Stirnseiten der Seitenplatten 10 sind mittels zusätzlicher Fixierstifte 18 eindeutig und unverdrehbar mit der Frontplatte 20 und der Rückwand 25 verbunden. Die Frontplatte 20 trägt Bohrungen 21 für die Befestigungsschrauben und Bohrungen 22 zur Aufnahme der Fixierstifte 18. Die Frontplatte 20 kann als einfaches Metall-Stanzteil hergestellt werden. Die Rückwand 25 trägt entsprechend Bohrungen 27 für die Befestigungsschrauben und Bohrungen 28 zur Aufnahme der Fixierstifte 18. Die Fixierstifte 18 können in durchgehend eingeformte Kanäle der Seitenplatten 10 eingesetzt werden.

An den von der Frontplatte 20 zu der Rückwand 25 verlaufenden Längskanten der Seitenplatten 10 sind zum Innenraum der Kassette gerichtete, horizontale Befestigungsflansche 11 und 12 angeformt, die zur Außenseite hin durch vertikale Abschlußstege 35 begrenzt sind. Damit werden auf der Bodenseite und der Deckseite eine Art Aufnahme für eine Bodenplatte oder eine Deckplatte 31 gebildet. Diese identisch ausgebildeten Platten tragen Bohrungen 32, die auf Gewindebohrungen 33 in den Befestigungsflanschen 11 und 12 der Seitenplatten 10 ausgerichtet sind. Damit lassen sich auch die offenen Seiten der Kassette verschließen, so daß eine allseitig geschlossene Kassette erhalten wird.

In den Eckbereichen der Seitenplatten 10, d.h. an den Übergängen zu den Befestigungsflanschen 11 und 12 sind vertikale Führungsstege 13 und 14 angeformt, die auf die Aufnahmenut der Führungsschienen des Baugruppenträgers abgestimmt sind. Mit zwei im entsprechenden Abstand im Baugruppenträger festgelegten Führungsschienen-Paare läßt sich die offene oder die geschlossene Kassette in den Baugruppenträger einschieben.

Die einander zugekehrten Innenseiten der Befestigungsflansche 11 und 12 einer Seitenplatte 10 sind selbst als Führungsschiene 36 zur Aufnahme einer Leiterplatte 40 ausgebildet. Diese Führungsschienen 36 liegen mit dem zugekehrten Führungssteg 13 oder 14 in einer gemeinsamen horizontalen Ebene. Die Rückwand 25 ist im Anschluß an eine Seitenplatte 10 und in Verlängerung der zugekehrten Führungsaufnahmen 36 mit einer Aussparung 26 versehen, durch die der Steckverbinder der Leiterplatte 40 aus der Kassette ragt und mit einem komplementären Steckverbinder des Baugruppenträgers verbunden werden kann.

Die horizontalen Kanten der Rückwand 25 tragen abgekantete Flansche 29 und 30, die sich zwischen die Befestigungsflansche 11 und 12 der beiden Seitenplatten 10 einführen lassen.

Damit die Kassette wie eine Leiterplatte in den Baugruppenträger eingesetzt werden kann, ist vorgesehen, daß die Breite der Frontplatte und der Rückwand so gewählt ist, daß an der Unterseite und der Oberseite der Kassette die Führungsstege einen Abstand aufweisen, der ein ganzzahliges Vielfaches einer Teilung entspricht, die für die Befestigung von Führungsschienen im Baugruppenträger vorgegeben ist, sowie daß der vertikale Abstand der Führungsstege dem vertikalen Abstand der Führungsschienen im Baugruppenträger entspricht. In dem Baugruppenträger brauchen dann nur zwei aufeinander ausgerichtete Führungspaare in entsprechendem horizontalen Abstand vorgesehen werden.

## Patentansprüche

1. Kassette zum Einbau in einen Baugruppenträger mit Führungsschienen für einschiebbare Leiterplatten,
zusammengesetzt aus
zwei identischen Seitenplatten (10), einer Boden- und einer Deckplatte (31), einer Frontplatte (20) und einer Rückwand (25), dadurch gekennzeichnet,
daß die Seitenplatten (10) an ihren von der Frontplatte (20) zur Rückwand (25) verlaufenden Längskanten mit nach innen versetzten, horizontalen Befestigungsflanschen (11,12) zum Anbringen der Boden- und der Deckplatte (31) versehen sind,
daß die Seitenplatten (10) in den Eckbereichen, d.h. an den Übergängen zu den Befestigungsflanschen (11,12), mit zum Einschieben in die Führungsschienen auf die Aufnahmenuten der Führungsschienen abgestimmten und ausgerichteten vertikalen Führungsstegen (13,14) versehen sind,
daß aus den Seitenplatten (10) Fenster (15) ausgestanzt sind,
daß die ausgestanzten Seitenplattenteile (16) wieder in die Fenster (15) der Seitenplatten (10) einsetzbar und darin festlegbar sind,
daß die vertikalen Stirnseiten der Seitenplatten (10) mit Gewindebohrungen (17) versehen sind und
daß die Frontplatte (20) und die Rückwand (25) entsprechend verteilte Bohrungen (21,27) zur Aufnahme von Befestigungsschrauben tragen.

2. Kassette nach Anspruch 1,
dadurch gekennzeichnet,
daß ihre Breite durch die Breite der Frontplatte (20) und der Rückwand (25) festgelegt ist.

3. Kassette nach Anspruch 1 oder 2,
dadurch gekennzeichnet,
daß die Seitenplatten (10) auf den einander zugekehrten Innenseiten mindestens einen durchgehenden, angeformten Schraubkanal (34) aufweisen, der zumindest in den an die vertikalen Stirnseiten der Seitenplatten (10) anschließenden Bereichen als Gewindebohrungen (17) ausgebildet ist.

4. Kassette nach einem der Ansprüche 1 bis 3,
dadurch gekennzeichnet,
daß ein einziger Schraubkanal (34) etwa in der Mitte der Höhe der Seitenplatten (10) angeformt ist und sich über die ausgestanzten Seitenplattenteile (16) erstreckt.

5. Kassette nach einem der Ansprüche 1 bis 4,
dadurch gekennzeichnet,
daß die Fenster (15) in den Seitenplatten (10) bis auf einen schmalen Steg an die vertikalen Stirnseiten der Seitenplatten (10) herangeführt sind und
daß die Enden des Schraubkanals (34) in den Seitenplattenteilen (16) als Gewindeaufnahmen ausgebildet sind.

6. Kassette nach einem der Ansprüche 1 bis 5,
dadurch gekennzeichnet,
daß die Befestigungsflansche (11,13) der Seitenplatten (10) vertikal nach außen abstehende Abschlußstege (35) tragen, die die Aufnahmen für die Boden- und Deckplatte (31) begrenzen.

7. Kassette nach einem der Ansprüche 1 bis 6,
dadurch gekennzeichnet,
daß die Befestigungsflansche (11,13) mit Gewindebohrungen (33) und die Boden- und die Deckplatte (31) mit darauf abgestimmten und ausgerichteten Befestigungsbohrungen (32) versehen sind.

8. Kassette nach einem der Ansprüche 1 bis 7,
dadurch gekennzeichnet,
daß die Befestigungsflansche (11,13) auf den einander zugekehrten Innenseiten als Führungsschiene (36) zur Aufnahme einer Leiterplatte (40) ausgebildet sind, die in gleicher horizontaler Ebene wie die an den zugeordneten Längskanten der Seitenplatten (10) angeformten Führungsstege (13,14) angeordnet sind.

9. Kassette nach einem der Ansprüche 1 bis 8,
dadurch gekennzeichnet,
daß die Rückwand (15) zumindest in dem an eine Seitenplatte (10) anschließenden Bereich mit einer Aussparung (26) zum Durchführen eines Steckverbinders einer in den zugekehrten Führungsschienen (36) der Seitenplatte (10) eingeschobenen Leiterplatte (40) versehen ist.

10. Kassette nach einem der Ansprüche 1 bis 9,
dadurch gekennzeichnet,
daß die Bodenplatte und die Deckplatte (31) identisch ausgebildet sind.

11. Kassette nach einem der Ansprüche 1 bis 10,
dadurch gekennzeichnet,
daß die Seitenplatten (10) als Abschnitt eines Metall-Extruderprofiles ausgebildet sind.

12. Kassette nach einem der Ansprüche 1 bis 11,
dadurch gekennzeichnet,
daß die Rückwand (25) an ihren horizontalen Kanten abgewinkelte Flansche (29,30) aufweist, die zwischen die zugekehrten Befestigungsflansche (11,13) der Seitenplatten (10) einführbar sind.

13. Kassette nach einem der Ansprüche 1 bis 12,
dadurch gekennzeichnet,
daß die Frontplatte (20) und die Rückwand (25) durch zusätzliche Fixierstifte (18) unverdrehbar an den Stirnseiten der Seitenplatten (10) festgelegt sind.

14. Kassette nach einem der Ansprüche 1 bis 13,
dadurch gekennzeichnet,
daß die Breite der Frontplatte (20) und der Rückwand (25) so gewählt ist, daß an der Unterseite und der Oberseite der Kassette die Führungsstege (13,14) einen Abstand aufweisen, der ein ganzzahliges Vielfaches einer Teilung entspricht, die für die Befestigung von Führungsschienen im Baugruppenträger vorgegeben ist.

15. Kassette nach einem der Ansprüche 1 bis 14,
dadurch gekennzeichnet,
daß der vertikale Abstand der Führungsstege (13,14) dem vertikalen Abstand der Führungsschienen im Baugruppenträger entspricht.

## Claims

1. Casing for installation in an assembly carrier provided with guide rails for insertable printed circuit boards, including two identical lateral panels (10), a base panel and a top panel (31), a front panel (20) and a rear wall (25), characterised in that the lateral panels (10) are provided, on their longitudinal edges extending from the front panel (20) to the rear wall (25), with inwardly offset, horizontal mounting flanges (11, 12) for attachment of the base panel and the top panel (31), in that the lateral panels (10) are provided, in the corner regions, i.e. at the transitional regions between the mounting flanges (11, 12), with vertical guide ribs (13, 14), which are adapted to, and aligned with, the receiving grooves in the guide rails, for insertion into the guide rails, in that windows (15) are punched-out of the lateral panels (10), in that the punched-out lateral panel portions (16) are re-insertable into the windows (15) of the lateral panels (10) and are securable therein, in that the vertical end faces of the lateral panels (10) are provided with threaded bores (17), and in that the front panel (20) and the rear wall (25) have correspondingly distributed bores (21, 27) for receiving mounting screws.

2. Casing according to claim 1, characterised in that its width is determined by the width of the front panel (20) and the rear wall (25).

3. Casing according to claim 1 or 2, characterised in that the lateral panels (10) have, on the insides facing each other, at least one continuous, moulded-on screw channel (34), which is provided, as threaded bores (17), in at least the regions communicating with the vertical end faces of the lateral panels (10).

4. Casing according to one of claims 1 to 3, characterised in that one single screw channel (34) is moulded substantially in the centre of the height of the lateral panels (10) and extends beyond the punched-out lateral panel portions (16).

5. Casing according to one of claims 1 to 4, characterised in that the windows (15) in the lateral panels (10) are supplied to the vertical end faces of the lateral panels (10) so as to leave a narrow web therebetween, and in that the ends of the screw channel (34) are provided as threaded receiving means in the lateral panel portions (16).

6. Casing according to one of claims 1 to 5, characterised in that the mounting flanges (11, 12) of the lateral panels (10) are provided with vertically outwardly protruding end webs (35), which define the receiving means for the base panel and the top panel (31).

7. Casing according to one of claims 1 to 6, characterised in that the mounting flanges (11, 12) are provided with threaded bores (33), and the base panel and the top panel (31) are provided with mounting bores (32), which are adapted to, and aligned with, said threaded bores.

8. Casing according to one of claims 1 to 7, characterised in that the mounting flanges (11, 12) are provided, on the insides facing each other, as guide rail (36) for receiving a printed circuit board (40), which flanges are disposed in the same horizontal plane as the guide ribs (13, 14), which are moulded to fit on the associated longitudinal edges of the lateral panels (10).

9. Casing according to one of claims 1 to 8, characterised in that the rear wall (25) is provided, at least in the region communicating with a lateral panel (10), with an aperture (26) for the guidance therethrough of a plug-in connector of a printed circuit board (40), which is inserted into the facing guide rails (36) of the lateral panel (10).

10. Casing according to one of claims 1 to 9, characterised in that the base panel and the top panel (31) have identical configurations.

11. Casing according to one of claims 1 to 10, characterised in that the lateral panels (10) form a portion of a metal extrusion profile.

12. Casing according to one of claims 1 to 11, characterised in that the rear wall (25) has flanges (29, 30), which are bent-over at its horizontal edges and are insertable between the facing mounting flanges (11, 12) of the lateral panels (10).

13. Casing according to one of claims 1 to 12, characterised in that the front panel (20) and the rear wall (25) are non-rotatably secured on the end faces of the lateral panels (10) by means of additional securing pins (18).

14. Casing according to one of claims 1 to 13, characterised in that the width of the front panel (20) and of the rear wall (25) is so selected that the guide ribs (13, 14) have a spacing, at the bottom and top of the casing, such spacing corresponding to an integer multiple of a separation, which is prescribed for the mounting of guide rails in the assembly carrier.

15. Casing according to one of claims 1 to 14, characterised in that the vertical spacing between the guide ribs (13, 14) corresponds to the vertical spacing between the guide rails in the assembly carrier.

## Revendications

1. Cassette à monter dans une boîte pour des cartes électroniques, avec des rails de guidage pour des cartes électroniques coulissantes, composée de deux plaques latérales identiques (10), d'une plaque de base et d'une plaque de recouvrement (31), d'une plaque frontale (20) et d'une paroi arrière (25),
caractérisée
par le fait que les plaques latérales (10) présentent, sur leurs arêtes longitudinales allant de la plaque frontale (20) vers la paroi arrière (25), des brides de fixation horizontales (11, 12) décalées vers l'intérieur, pour la fixation de la plaque de base et de la plaque de recouvrement (31),
par le fait que les plaques latérales (10) présentent dans les régions d'angle, c'est-à-dire dans les zones de transition vers les brides de fixation (11, 12), des nervures de guidage (13, 14) verticales, harmonisées avec les rails de guidage et orientées parallèlement à celles-ci avec des rainures de réception destinées au coulissement des rails de guidage,
par le fait que des regards (15) sont découpés dans les plaques latérales (10),
par le fait que les éléments (16) découpés dans les plaques latérales peuvent être réinsérés dans les regards (15) des plaques latérales (10) et peuvent y être fixés,
par le fait que les faces frontales verticales des plaques latérales (10) présentent des forures filetées (17) et
par le fait que la plaque frontale (20) et la paroi arrière (25) présentent des forures (21, 27) distribuées de manière appropriée pour la réception de vis de fixation

2. Cassette suivant la revendication 1,
caractérisée
par le fait que sa largeur est fonction de la largeur de la plaque frontale (20) et de la paroi arrière (25).

3. Cassette suivant la revendication 1 ou la revendication 2,
caractérisée
par le fait que les plaques latérales (10) présentent sur leurs faces intérieures, en regard l'une de l'autre, au moins un canal à vis (34) continu et formé sur ces plaques, canal qui, tout au moins dans les régions voisines des côtés frontaux verticaux des plaques latérales (10), a la forme d'une forure filetée (17).

4. Cassette suivant l'une quelconque des revendications de 1 à 3,
caractérisée
par le fait qu'un seul canal à vis (34) est formé sensiblement au milieu de la hauteur des plaques latérales (10) et s'étend au-dessus des éléments découpés des plaques latérales (16).

5. Cassette suivant l'une quelconque des revendications de 1 à 4,
caractérisée
par le fait que les regards (15) dans les plaques latérales (10) se prolongent, sauf en ce qui concerne une étroite nervure, jusqu'aux faces frontales verticales des plaques latérales (10) et
par le fait que les extrémités du canal à vis (34), dans les éléments (16) découpés dans les plaques latérales, ont la forme de logements filetés.

6. Cassette suivant l'une quelconque des revendications de 1 à 5,
caractérisée
par le fait que les brides de fixation (11, 12) des plaques latérales (10) portent des nervures de clôture (35) issues verticalement vers l'extérieur, nervures qui délimitent les réceptions pour la plaque de base et la plaque de recouvrement (31).

7. Cassette suivant l'une quelconque des revendications de 1 à 6,
caractérisée
par le fait que les brides de fixation (11, 12) présentent des forures filetées et que la plaque de base et de recouvrement (31) sont dotées de forures de fixation (32) harmonisées et en alignement avec les forures filetées (33).

8. Cassette suivant l'une quelconque des revendications de 1 à 7,
caractérisée
par le fait que les brides de fixation (11, 12) ont, sur les faces intérieures en regard l'une de l'autre, la forme d'un rail de guidage (36) pour la réception d'une carte électronique (40), rails de guidage qui sont disposés dans le même plan horizontal que les nervures de guidage (13, 14) formées sur les arêtes longitudinales correspondantes des plaques latérales (10).

9. Cassette suivant l'une quelconque des revendications de 1 à 8,
caractérisée
par le fait que la paroi arrière (15), tout au moins dans une région voisine de la plaque (10), présente un évidement (26) pour le passage d'un connecteur à fiche d'une carte électronique (40), introduite par glissement dans les rails de guidage (36) faisant face à la plaque latérale (10).

10. Cassette suivant l'une quelconque des revendications de 1 à 9,
caractérisée
par le fait que la plaque de base et la plaque de recouvrement (31) sont de forme identique.

11. Cassette suivant l'une quelconque des revendications de 1 à 10,
caractérisée
par le fait que les plaques latérales (10) sont constituées par un tronçon d'un profilé métallique extrudé.

12. Cassette suivant l'une quelconque des revendications de 1 à 11,
caractérisée
par le fait que la paroi arrière (25) présente sur ses arêtes horizontales des brides coudées (29, 30) qui peuvent être introduites entre les brides de fixation se faisant face (11, 12) des plaques latérales (10).

13. Cassette suivant l'une quelconque des revendications de 1 à 12,
caractérisée
par le fait que la plaque frontale (20) et la paroi arrière (25) sont bloquées à l'abri de la rotation à l'aide de chevilles de fixation supplémentaires (18) sur les faces frontales des plaques latérales (10).

14. Cassette suivant l'une quelconque des revendications de 1 à 13,
caractérisée
par le fait que la largeur de la plaque frontale (20) et de la paroi arrière (25) sont choisies de manière telle qu'à la face inférieure et à la face supérieure de la cassette, les nervures de guidage (13, 14) sont distantes d'une valeur qui correspond à un multiple entier d'un pas, imposé pour la fixation de rails de guidage dans la cassette à monter dans une boîte pour des cartes électroniques.

15. Cassette suivant l'une quelconque des revendications de 1 à 14,
caractérisée
par le fait que la distance verticale des nervures de guidage (13, 14) correspond à la distance verticale des rails de guidage dans la cassette à monter dans une boîte pour des cartes électroniques.
